# EUROPEAN PATENT SPECIFICATION

(11) **EP 2 077 559 B1**
(45) Date of publication and mention of the grant of the patent: **07.11.2012**
(21) Application number: 08012119.7
(22) Date of filing: 04.07.2008
(51) Int. Cl.: G11C 16/34

(54) **Refresh method of a flash memory**
Aktualisierungsverfahren für einen Flash-Speicher
Procédé de rafraîchissement d'une mémoire flash

(30) Priority: 27.12.2007 JP 2007336047; 19.02.2008 JP 2008037139
(43) Date of publication of application: 08.07.2009
(73) Proprietor: Hagiwara Solutions Co., Ltd., Nakaku, Nagoya, Aichi (JP)
(72) Inventor: Oribe, Hiromichi, Nagoya-shi Aichi-Ken 460-0003 (JP); Orihashi, Teruki, Nagoya-shi Aichi-Ken 460-0003 (JP)
(74) Representative: Wiebusch, Manfred

(56) References cited:
- US-A- 5 715 193
- US-A1- 2006 039 196
- US-A1- 2009 034 328

## Description

### Technical Field

The present invention relates to a refresh method of a flash memory, in particular, a NAND-type flash memory.

### Background Art

A flash memory is known as a type of an electrically erasable and programmable read-only memory (EEPROM). A flash memory is a memory to which data are written (also called "programmed") by charging a cell located at an intersection of a word line and a bit line. Even if the power is turned off, the data are not lost as long as the electric charge is accumulated in the cell. However, a so-called "read disturb error" may occur in a flash memory. The read disturb error is a phenomenon in which, when data on a certain page of a certain physical block are read out frequently, data being stored in a cell on other pages of the data read block are changed.

Such a phenomenon occurs because, when data are read out from a selected cell, electric charge is injected into a floating gate of a non-selected cell, and thus the non-selected cell is virtually weakly programmed. Therefore, much more cells are affected as the number of data read operations is increased. For this reason, the flash memory must be refreshed when the number of data read operations is increased. The "refresh" means rewriting data of a physical block. The number of data read operations at which the refresh should be executed is usually specified by the vendor. For example, among currently available products, the single-level cell (SLC) type has the limit of the number of data read operations of 100,000 to 1,000,000 and the multi-level cell (MLC) type has the limit of the number of data read operations of 10,000 to 100,000 (generally, these limits tend to be lowered as the number of data reading operations is increased).

References to prior publications:
- Unexamined Japanese Patent Application Publication No. 10-228783
- Unexamined Japanese Patent Application Publication No. 2002-150783
- Unexamined Japanese Patent Application Publication No. 2004-326867
- Granted Japanese Patent No. 3641066
- US 2006/039196 A1 discloses a refresh method according to the preamble of claim 1.

### Problems of Prior Art

In the prior art of the refresh method, the number of data read operations is counted for each physical block and such a physical block for which the number of data read operations has reached a certain value specified by the vendor is refreshed when the data of such physical block are just read (specifically, immediately after or immediately before the data are read). For this reason, when the respective numbers of data read operations of multiple physical blocks have reached their specified value simultaneously, refreshes must be continuously executed. This makes keeping of a certain data transfer rate difficult. As a result, there may occur a problem that data transfer into the host is temporarily interrupted to such an extent that inconvenience is caused to the user.

Accordingly, an object of the present invention is to provide a flash memory refresh method that efficiently and reliably prevents data from changing due to a read disturb error, and also prevents that a transfer of data to a host is temporarily interrupted to such an extent that inconvenience is caused to the user. Other objects will be apparent from the specification, and the appended drawings and claims, in particular, the claims.

To achieve the above-described objects, the present invention employs a method for refreshing a flash memory as defined in claim 1. Further embodiments are defined in the dependent claims.

### Disclosure of the Invention

### Brief Description of the Drawings

- Fig. 1: is an example of a basic configuration of a system for performing an embodiment of the present invention;
- Fig. 2: is an example of a refresh management table;
- Fig. 3: is an example of the relation between the vendor-specified value and the controller threshold, regarding the number of data read operations, for each range of numbers of data erasure operations (each phase);
- Fig. 4: is an example of a method for executing a refresh;
- Fig. 5: is an example of a refresh management table at the stage of shipping.

### Best Mode for Carrying Out the Invention

Preferred embodiments of the present invention will now be described with reference to the accompanying drawings.

### (Basic System Configuration)

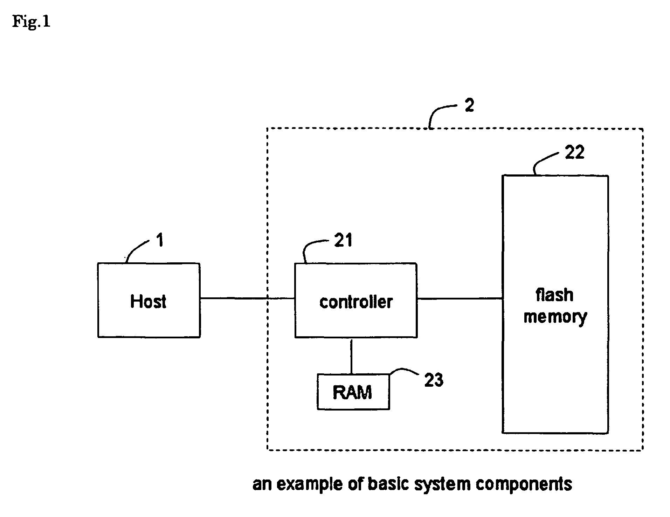

The present invention is worked on a system basically including: a flash memory device 2 comprised of a NAND-type flash memory 22 (simply referred to as a "flash memory" in this specification except for cases where it must be referred to as "NAND-type flash memory") and a controller 21 for writing or reading data to or from the flash memory 22; and a host 1 for issuing a data write command or a data read command to the device 2 (see Fig. 1). A RAM 23 is coupled to the controller 21, but if necessary, the RAM 23 may be provided within the controller 21.

The flash memory device 2 and host 1 may be integrated with each other as a certain system such as an MPEG music player via IDE (ATA) Interface for example. The host I also may be a personal computer (PC), and the flash memory device 2 may be constructed by a separate device such as one to be attached to the PC via a certain interface such as an IDE or a universal serial bus (USB) and so on. It is preferable that these interfaces can let the command issued from the host 1 pass to the device 2.

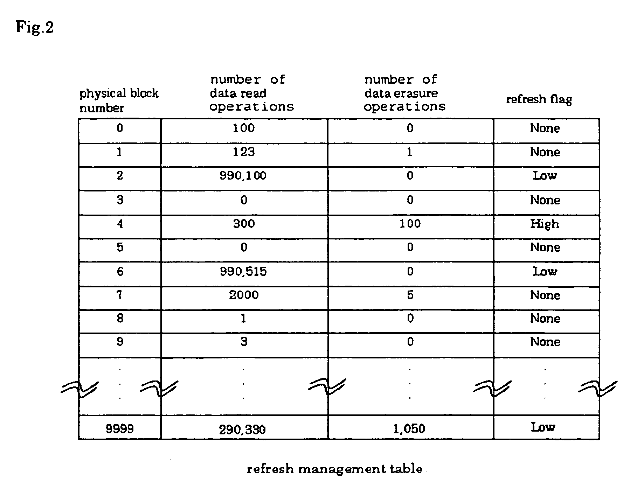

The flash memory 22 includes multiple physical blocks. As known, the flash memory 22 includes a management area as well as a user data area. Also, in this embodiment, the device 2 includes a refresh management table. Data on the refresh management table can be stored in the management area of the flash memory 22 in a non-volatile manner. By using the refresh management table, the controller 21 records the respective number of data read operations and the number of data erasure operations of physical blocks in a non-volatile manner and manages it (see Fig. 2). Each physical block is associated with logical block one to one correspondence in a logic block address / physical block address conversion table (not shown).

When the system is powered on, the refresh management table is copied into the RAM 23 from said management area of the flash memory 22. Now assume that there are physical blocks of which number is from "0" to "9999" in a flash memory 22. When the controller 21 reads data from a certain physical block, the controller 21 records/updates the number of data read operations in the refresh management table (the column of "the number of data read operations " in Fig. 2). The number that data erasure operations have been executed on the physical block in the past is recorded in the column of "the number of data erasure operations " of the refresh management table (note that "erasure" is a concept including a rewrite of data of the block).

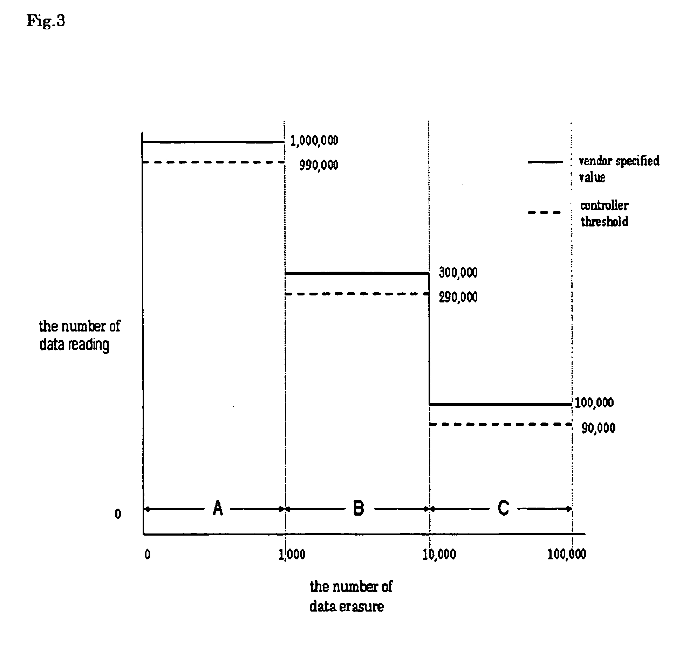

The limit of the number of data read operations for the physical block depends on the number of data erasure operations that has been executed in the past. In general, the limit tends to be lowered as the number of data erasure operations that has been executed in the past is increased (see Fig. 3). As shown in Fig. 3, if the number of data erasure operations (total number of data erasure operations) of a physical block is 0 to 999, the limit (vendor-specified value in Fig. 3) is 1,000,000 (range A in Fig. 3). If the total number of data erasure operations is 1,000 to 9,999, the limit is 300,000 (range B in Fig. 3). If the total number of data erasure operations is 10,000 to 99,999, the limit is 100,000 (range C in Fig. 3). In this embodiment, each threshold (the controller thresholds in the phases A, B, and C of Fig. 3) is set to a smaller value than vendor-specified value. If the number of data read operations of a physical block has reached such a controller threshold, a refresh flag is set in the refresh management table (flag "Low" in the column of "refresh flag").

In the prior art of the refresh method, when the controller 21 receives a data read command from the host 1 and the number of data read operations of the physical block is found to have reached its limit (vendor-specified value), the data read operation by CPU (within a controller 21 thereinafter, not shown) is interrupted in order to refresh the physical block. In this embodiment, refresh operations by CPU are collectively executed later using the refresh management table and a certain method (to be discussed later).

In this case, if the controller threshold that is a criterion for executing a refresh operation is set to the same value as the vendor-specified value, the number of data read operations may exceed the above-described limit between the time when the data read command has been issued from the host 1 and the time when a refresh starts. This is inconvenient. For this reason, the controller threshold is set to a value lower than the vendor-specified value so that a refresh is effectively executed before the number of data read operations reaches its limit.

Note that if the power supply of the system is shut off, the data of the refresh management table are recorded in the management area in the flash memory 22 in a non-volatile manner, and the table is copied into the RAM 23 when to power is supplied the system next time. Also, because the power supply may be shut off for some reason, it is preferable that the data of the refresh management table in the RAM 23 are recorded or updated in a management area of the flash memory 22, e.g. every 10 minutes.

A refresh is executed by means of using the following method.

### (Auto-refresh)

This is a refresh method in which the controller 21 automatically executes a refresh using both a timer of itself and a previously installed program, firmware in the controller 21, which is executed on a basis of a time event.

The auto-refresh operation may be set so as to be executed at predetermined time intervals, e.g. every several seconds or every several minutes, while the device 2 is powered on. In such a system, as the power is on at all times, the auto-refresh may be set so as to be executed at a predetermined time, e.g. 9:00 in the morning.

If a timer event occurs when a write or read command is not issued from the host 1 to the controller 21 and a flag (Low) is set for one or more physical blocks at this time, the controller 21 executes a refresh.

Firstly the controller 21 searches the refresh management table. Then if it is detected that there are multiple physical blocks that a refresh flag (Low) is being set, CPU determines to which range (A, B or C) the respective number of data erasure operations of the related physical blocks belongs.

Then, the physical blocks are refreshed in descending order of the number of data read operations exceeding its controller threshold. That is to say, a refresh is executed on a block by block basis. In an other way, the physical blocks may be refreshed in descending order of the proximity of the number of data read operations to its vendor-specified value.

In Fig. 3, the differences between the vendor-specified value and controller threshold in each range (A, B and C) are identical to one another. Therefore, the former refresh order is quite the same as the latter refresh order.

However, if the controller thresholds are set such that the vendor-specified value and the controller threshold are different from one another in each range (A, B and C), it will be understood that the former refresh order is different from the latter refresh order. By using the above-mentioned two methods, the physical blocks are refreshed in descending order of the likelihood of causing a read disturb error. Thus, a read disturb error is more reliably prevented.

If the timer event occurs when the controller 21 is executing a media access (data read) according to a command from the host 1, and if multiple physical blocks are required to be refreshed, a refresh is executed at given or predetermined time intervals, from the start of refresh of one physical block to the start of a refresh of the next physical block, for each physical block.

It takes 100 ms (milliseconds) at the most from the start of a refresh of one physical block to the completion thereof. For this reason, the refresh interval can be set to, e.g., 1 second. That is, refresh is executed in a time-sharing manner i.e. by interrupting the continuous media access.

Thus, even if there are multiple blocks required to be refreshed in the ongoing process, data transfer from the flash memory 22 to the host 1 is not interrupted. In particular, even if contents stored in the flash memory 22 are music, moving images or the like and multiple physical blocks reach their respective steps which must be refreshed all at once, a certain data transfer rate is maintained by means of refreshing in a time-sharing manner. Thus, no inconvenience is caused to the user.

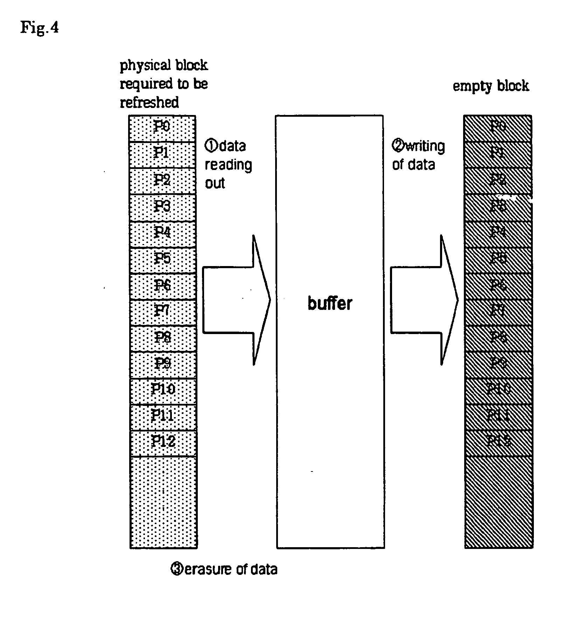

The refresh method will now be concretely described with reference to Fig. 4. First, one of the spare blank blocks is allocated for the refresh. Next, CPU reads out all the data of a related physical block to a buffer existing within a flash memory 22 in a unit of page one after another. Then CPU writes all the data in the buffer to the spare block. All the data of the original block are erased and the logic block address / physical block address conversion table and a blank block table are updated. Also, the number of data read operations of the original block is reset to "0" and the number of data erasure operations is incremented by 1 (one).

In a prior art, first, 1) data of a physical block are temporarily stored in a buffer, next, 2) the data of the physical block are erased, and then 3) the buffer-stored data are rewritten to the original block. In this case, if the power supply is shut off for some reason after the above step 2) and before the above step 3), the original data are quite erased. In this regard, according to the present invention, whenever the power supply is shut off, the original data will not be lost.

### (Refresh operation on a basis of the COMMAND from the host)

Besides the auto-refresh mentioned above, the refresh may be also executed using such a method that host 1 issues a predetermined command to the controller 21 when the host 1 is not performing a media access. The following commands may be previously programmed in a driver software of the host 1.

### 1. GET REFRESH PENDING STATUS COMMAND

This is a command to get the controller 21 notifying the host 1 of the number of physical blocks of which refresh flag ("Low", or "High" to be discussed later) is set in the refresh management table of the RAM 23.

### 2. EXECUTE REFRESH COMMAND

This is a command to get the controller 21 refreshing. The number of physical blocks to be refreshed may be also specified using this command.

### 3. SAVE REFRESH TABLE COMMAND

This is a command to get the controller 21 storing data of the refresh management table into the management area of a flash memory 22. Upon completing such storing, this command completes.

Below command-issue order is preferable.
a) The host 1 firstly issues GET REFRESH PENDING STATUS COMMAND in order to grasp the number of blocks required to be refreshed.
b) The host 1, when blocks required to be refreshed are found, issues EXECUTE REFRESH COMMAND to the controller 21 at a time when the controller 21 is not performing a media access so as to cause the controller 21 to execute a refresh according to the program. According to this command, because the refresh is executed only when it should be done, the system performance is improved.
c) The host 1 issues SAVE REFRESH TABLE COMMAND so as to cause the controller 21 to store the data of the refresh management table of the RAM 23 into the management area of the flash memory 22 at a predetermined time interval in a non-volatile manner as necessary. According to this command, data of the refresh management table are efficiently protected even though the power supply shut down for some reason.

According to the above embodiment, it will be understood that transfer of the digital contents such as music or moving images to the host 1 from the flash memory 22 is not so interrupted that inconvenience is caused to the user.

### (Coping with Bit Errors)

When user data are written to a flash memory system, an error check code created during the data write operation is added to the user data. When the data are read, it is checked according to the error check code whether or not there is an error in the written data. If the number of bit errors is equal to or less than controller ability (e.g., 8 bit), the bit errors can be corrected. If the number of bit errors is more than controller ability, the bit error can not be corrected. This means that the block has become a bad (i.e. defective) block due to numerous data write or erase operations.

Accordingly, in this refresh method of the present invention, in order to assure safety, when the number of bit errors in a certain physical block has reached a predetermined value less than the controller ability, e.g. 7 bit, the data of such a physical block are rewritten to a spare block and the original physical block that has been used until then is regarded as a bad block.

In that case, CPU especially set a refresh flag "High" for such a physical block of the refresh management table (see column of "refresh flag" in Fig. 2).

In Fig. 2, the flag "High" is being set for the physical block number "4". If such a flag "High" is set; such a physical block is regarded as a bad block, and the data of the bad block are written to the spare block prior to refreshing a physical block (flag "Low") of which the number of data read operations has reached its controller threshold. This is because of an emergency.

Coping with such an emergency is also performed, a) corrected data of the error-found block are temporarily stored in the buffer, next, b) the stored data are rewritten to the spare blank block, then c) the original data of the error-found block are erased, and then d) the relation between the physical block number to which data have been newly written and the logic block number is updated in the logic block address / physical block address conversion table. The bad blocks are disabled. Though the rewrite of the data of the bad block to the spare block so as to cope with bit errors is not exactly a refresh, it is treated as a "refresh" in this present invention. It is one of the characteristics of this invention. This is because such a bad block is also managed in the refresh management table and the data of the original block is rewritten to the spare block same as a refresh. Thus, a media access, a refresh and coping with a bad block can be efficiently executed in a collective manner. As the result, system performance can be improved.

If the RAM 23 is externally attached to the controller 21, it may be a dynamic random access memory (DRAM) or a SDRAM (synchronous DRAM).

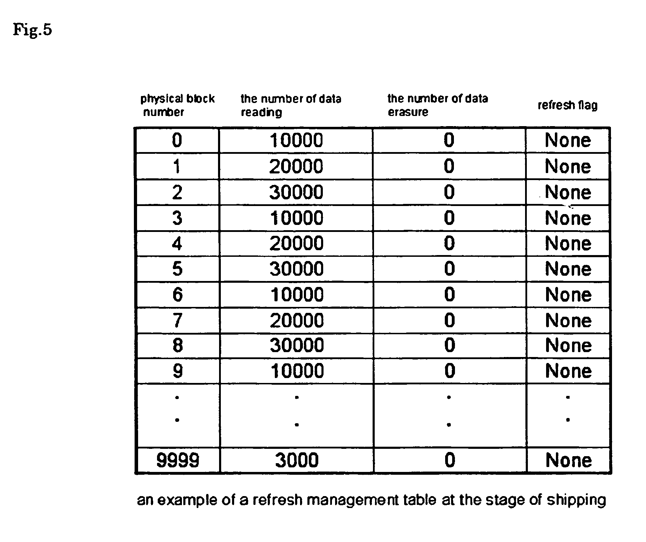

In addition, as shown in Fig. 5, a different value of the number of data read operations (as a dummy data) may be set to each physical block in the refresh management table before shipping. This enable the refresh further divided manner and it is suitable to such a system as constantly performs a sequential data read.

In a game machine or the like, the contents data are read so many times within a day and generally the contents data are managed in a unit of a tile of which data are composed of a multiple physical blocks.

In such a case, it is preferable for the system to record in the refresh management table the number of reading operations of every file which accommodates data of such a game contents, when the system is turned on each morning, to retrieve the daily maximum number of reading operations of such files or calculate a daily average of the number of reading operations of each file up to the previous day, to anticipate whether the flag(s) will be set within the day to certain physical block(s) in which the contents data are stored, and when the anticipated result is "yes", to refresh the expected physical block(s) before the system is provided to the players in the day. This is a feedforward control.

## Claims

1. A method for refreshing a flash memory (22) that is divided into a plurality of physical blocks, comprising:
- storing, updating, and monitoring the number of data read operations and of data erasure operations for each physical block;
- setting a refresh flag for a physical block when the number of data read operations of the physical block has reached a predetermined controller threshold; and
- executing a refresh according to the state of the flag,
**characterized in that** a refresh management table, in which said numbers of data read and erasure operations are stored and updated, is provided in a flash memory device (2); and said predetermined controller threshold depends upon the number of erasure operations that the given block has experienced.

2. The method according to claim 1, wherein the controller threshold is set to a value that is lower than a vendor-specified value.

3. The method according to any of claims 1 and 2, wherein the refresh is executed as a timer event regardless of whether or not a media access takes place.

4. The method according to claim 3, wherein, if there are multiple physical blocks to be refreshed, the refreshes are executed for an entire physical block at a time, waithin predetermined time interval.

5. The method according to any one of claims 1 and 2, wherein a host (1) issues a refresh command to a controller (21) while the controller is not performing a media access.

6. The method according to claim 5, wherein the physical blocks required to be refreshed are refreshed in descending order of proximity of the number of data read operations to the vendor-specified value.

7. The method according to claim 6, wherein the refresh is executed by:
a) temporarily storing data of each of the physical blocks to a buffer,
b) writing each of the read data to a spare blank block,
c) erasing the data of each of the physical blocks in which the original data are stored, and
d) updating a relation between each of the physical blocks in which data are newly written and a logic block in a logic block address / physical block address conversion table.

8. The method according to claim 7, wherein, if the number of bit errors detected by using an error correction circuit has reached a controller ability value or a predetermined value smaller than the controller ability value, a refresh flag "High" is set to indicate a physical block where bit errors occurred, in a refresh management table, and such a physical block is refreshed on a top-priority and emergency basis.

9. The method according to claim 1, wherein;
- a management area of the flash memory (22) is provided with a area for storing the data of the refresh management table in non-volatile manner,
- when the system is powered on, the refresh management table is copied into a controller (21) of the flash memory or in a RAM (23) externally attached to the controller (21),
- the numbers of data read operations and of data erasure operations are stored and updated for each physical block in the refresh management table so that a refresh is executed, and
- when the system is powered off, the data of the refresh management table in the RAM (23) is stored in a non-volatile manner in the flash memory (22).

10. The method according to claim 2, wherein the controller threshold is set to a different value according to each range of the number of data erasure operations of each physical block.

11. The method according to any one of claims 1 to 10, wherein different dummy data of the number of data read operations is set to each physical block in the refresh management table before shipping.

12. The method according to claim 3, executed in a game machine, comprising:
- recording, every day, the number of reading operations of each file which accommodates the game contents,
- when the machine is turned on in the morning, retrieving the daily maximum number of reading operations of the file up to the previous day or calculating a daily average of the number of reading operations of each file,
- anticipating whether the flag(s) will be set during the day to certain physical blocks in which the contents data are stored, and
- when the anticipated result is "yes", refreshing the said physical blocks before the machine is offered for the player(s) in the day.

## Patentansprüche

1. Verfahren zum Auffrischen eines Flash-Speichers (22), der in eine Vielzahl von physikalischen Blöcken aufgeteilt ist, mit:
- Speichern, Aktualisieren und Überwachen der Anzahl von Datenleseoperationen und Datenlöschoperationen für jeden physikalischen Block,
- Setzen eines Refresh-Flags für einen physikalischen Block, wenn die Anzahl von Datenleseoperationen für den physikalischen Block einen vorbestimmten Steuerungs-Schwellenwert erreicht hat, und
- Ausführen eines Refreshs je nach Zustand des Flags,
**dadurch gekennzeichnet, dass** in einer Flash-Speichereinrichtung (2) eine Refresh-Verwaltungstabelle vorgesehen ist, in der die genannten Anzahlen von Datenlese- und Datenlöschoperationen gespeichert und aktualisiert werden, und dass der genannte vorbestimmte Steuerungs-Schwellenwert von der Anzahl der Löschoperationen abhängig ist, die der betreffende Block erfahren hat.

2. Verfahren nach Anspruch 1, bei dem der Steuerungs-Schwellenwert auf einen Wert eingestellt ist, der niedriger ist als ein herstellerspezifischer Wert.

3. Verfahren nach Anspruch 1 oder 2, bei dem der Refresh als ein Timer-Ereignis ausgeführt wird, unabhängig davon, ob ein Medienzugriff stattfindet oder nicht.

4. Verfahren nach Anspruch 3, bei dem, wenn mehrere physikalische Blöcke aufzufrischen sind, die Refreshs für einen kompletten physikalischen Block auf einmal durchgeführt werden, und zwar innerhalb eines vorbestimmten Zeitintervalls.

5. Verfahren nach Anspruch 1 oder 2, bei dem ein Host (1) einen Refresh-Befehl an eine Steuerung (21) ausgibt, während die Steuerung keinen Medienzugriff ausführt.

6. Verfahren nach Anspruch 5, bei dem die physikalischen Blöcke, die einen Refresh benötigen, in absteigender Reihenfolge geordnet nach der Nähe der Anzahl der Datenleseoperationen zu dem herstellerspezifischen Wert aufgefrischt werden.

7. Verfahren nach Anspruch 6, bei dem der Refresh ausgeführt wird durch:
a) vorübergehendes Speichern von Daten jedes der physikalischen Blöcke in einem Puffer,
b) Schreiben sämtlicher der gelesenen Daten in einen in Reserve gehaltenen leeren Block,
c) Löschen der Daten jedes der physikalischen Blöcke, in denen die ursprünglichen Daten gespeichert sind, und
d) Aktualisieren einer Beziehung zwischen jedem der physikalischen Blöcke, in welche Daten neu eingeschrieben werden, und einem logischen Block in einer Umwandlungstabelle zur Umwandlung von logischen Blockadressen in physikalische Blocksdressen.

8. Verfahren nach Anspruch 7, bei dem, wenn die Anzahl von Bitfehlern, die durch Verwendung einer Fehlerkorrekturschaltung detektiert wurden, einen Steuerungs-Qualifikationswert erreicht hat oder einen vorbestimmten Wert, der kleiner ist als der Steuerungs-Qualifikationswert, ein Refresh-Flag "Hoch" in einer Refresh-Verwaltungstabelle gesetzt wird, um einen physikalischen Block anzugeben, in dem Bitfehler aufgetreten sind, und ein solcher physikalischer Block als Notmassnahme mit höchster Priorität aufgefrischt wird.

9. Verfahren nach Anspruch 1, bei dem
- ein Verwaltungsbereich des Flash-Speichers (22) einen Bereich zur Speicherung der Daten der Refresh-Verwaltungstabelle auf nichtflüchtige Weise aufweist,
- wenn das System eingeschaltet wird, die Refresh-Verwaltungstabelle in eine Steuerung (21) des Flash-Speichers oder einen RAM (23) kopiert wird, der an die Steuerung (21) angeschlossen ist,
- die Anzahlen von Datenleseoperationen und Datenlöschoperationen für jeden physikalischen Block in der Refresh-Verwaltungstabelle gespeichert und aktualisiert werden, so dass ein Refresh ausgeführt wird, und
- wenn das System ausgeschaltet wird, die Daten der Refresh-Verwaltungstabelle in dem RAM (23) auf nichtflüchtige Weise im Flash-Speicher (22) gespeichert werden.

10. Verfahren nach Anspruch 2, bei dem der Steuerungs-Schwellenwert für jeden Bereich der Anzahlen von Datenlöschoperationen jedes physikalischen Blockes auf einen anderen Wert eingestellt wird.

11. Verfahren nach einem der Ansprüche 1 bis 10, bei dem in der Refresh-Verwaltungstabelle vor dem Versand für jeden physikalischen Block unterschiedliche Blinddaten für die Anzahl von Datenleseoperationen eingestellt werden.

12. Verfahren nach Anspruch 3, ausgeführt in einem Spielgerät, mit:
- täglichem Aufzeichnen der Anzahl von Leseoperationen jeder Datei, die die Inhalte des Spiels enthält,
- wenn das Gerät am Morgen eingeschaltet wird, Abrufen der täglichen Höchstzahl von Leseoperationen der Datei bis zum vorherigen Tag oder Berechnen eines täglichen Mittelwertes der Anzahl von Leseoperationen für jede Datei,
- Abschätzen, ob das Flag oder die Flags für bestimmte physikalische Blöcke, in denen Inhaltsdaten gespeichert werden, während dieses Tages gesetzt werden wird, und
- wenn das Ergebnis der Abschätzung "Ja" ist, Auffrischen der genannten physikalischen Blöcke bevor das Gerät an diesem Tag dem Spieler oder den Spielern bereitgestellt wird.

## Revendications

1. Procédé de rafraîchissement d'une mémoire flash (22) qui est divisée en une pluralité de blocs physiques, consistant à :
- mémoriser, mettre à jour et surveiller le nombre d'opérations de lecture de données et d'opérations d'effacement de données pour chaque bloc physique ;
- positionner un indicateur de rafraîchissement pour un bloc physique lorsque le nombre d'opérations de lecture de données du bloc physique a atteint un seuil de contrôleur prédéterminé ; et
- exécuter un rafraîchissement en fonction de l'état de l'indicateur,
**caractérisé en ce qu'**une table de gestion de rafraîchissement, dans laquelle lesdits nombres d'opérations de lecture et d'effacement de données sont mémorisés et mis à jour, est prévue dans un dispositif de mémoire flash (2) ; et ledit seuil de contrôleur prédéterminé dépend du nombre d'opérations d'effacement que le bloc donné a subi.

2. Procédé selon la revendication 1, dans lequel le seuil de contrôleur est fixé à une valeur qui est inférieure à une valeur spécifiée par un vendeur.

3. Procédé selon l'une quelconque des revendications 1 et 2, dans lequel le rafraîchissement est exécuté en tant qu'événement de registre d'horloge indépendamment du fait qu'un accès au support ait lieu ou non.

4. Procédé selon la revendication 3, dans lequel, s'il y a de multiples blocs physiques à rafraîchir, les rafraîchissements sont exécutés pour un bloc physique entier en une fois, dans un intervalle de temps prédéterminé.

5. Procédé selon l'une quelconque des revendications 1 et 2, dans lequel un hôte (1) délivre une commande de rafraîchissement à un contrôleur (21) alors que le contrôleur n'effectue pas un accès au support.

6. Procédé selon la revendication 5, dans lequel les blocs physiques qui doivent être rafraîchis sont rafraîchis dans l'ordre descendant de la proximité du nombre d'opérations de lecture de données vers la valeur spécifiée par le vendeur.

7. Procédé selon la revendication 6, dans lequel le rafraîchissement est exécuté :
a) en mémorisant temporairement les données de chacun des blocs physiques dans une mémoire tampon,
b) en écrivant chacune des données lues dans un bloc vide de réserve,
c) en effaçant les données de chacun des blocs physiques dans lesquels les données d'origine sont mémorisées, et
d) en mettant à jour une relation entre chacun des blocs physiques dans lesquels des données sont nouvellement écrites et un bloc logique dans une table de conversion adresse de bloc logique/adresse de bloc physique.

8. Procédé selon la revendication 7, dans lequel, si le nombre d'erreurs sur les bits détectées en utilisant un circuit de correction d'erreur a atteint une valeur de capacité de contrôleur ou une valeur prédéterminée inférieure à la valeur de capacité de contrôleur, un indicateur de rafraîchissement est positionné au niveau « haut » pour indiquer un bloc physique où des erreurs sur les bits ont eu lieu, dans une table de gestion de rafraîchissement, et un tel bloc physique est rafraîchi sur une base de priorité plus élevée et d'urgence.

9. Procédé selon la revendication 1, dans lequel :
- une zone de gestion de la mémoire flash (22) est pourvue d'une zone pour mémoriser les données de la table de gestion de rafraîchissement d'une manière non volatile,
- lorsque le système est mis en marche, la table de gestion de rafraîchissement est copiée dans un contrôleur (21) de la mémoire flash ou dans une RAM (23) attachée extérieurement au contrôleur (21),
- les nombres d'opérations de lecture de données et d'opérations d'effacement de données sont mémorisés et mis à jour pour chaque bloc physique dans la table de gestion de rafraîchissement de sorte qu'un rafraîchissement soit exécuté, et
- lorsque le système est arrêté, les données de la table de gestion de rafraîchissement dans la RAM (23) sont mémorisées d'une manière non volatile dans la mémoire flash (22).

10. Procédé selon la revendication 2, dans lequel le seuil de contrôleur est fixé à une valeur différente en fonction de chaque plage du nombre d'opérations d'effacement de données de chaque bloc physique.

11. Procédé selon l'une quelconque des revendications 1 à 10, dans lequel différentes données fictives du nombre d'opérations de lecture de données sont placées pour chaque bloc physique dans la table de gestion de rafraîchissement avant expédition.

12. Procédé selon la revendication 3, exécuté dans une machine de jeu, consistant à :
- enregistrer, chaque jour, le nombre d'opérations de lecture de chaque fichier qui contient le contenu de jeu,
- lorsque la machine est mise en marche dans la matinée, récupérer le nombre maximum journalier d'opérations de lecture du fichier jusqu'au jour précédent ou calculer une moyenne journalière du nombre d'opérations de lecture de chaque fichier,
- anticiper si le ou les indicateurs seront positionnés pendant la journée pour certains blocs physiques dans lesquels les données de contenu sont mémorisées, et
- lorsque le résultat anticipé est « oui », rafraîchir lesdits blocs physiques avant que la machine soit offerte au ou aux joueurs dans la journée.
